# EUROPÄISCHE PATENTSCHRIFT

(11) **EP 3 914 448 B1**
(45) Veröffentlichungstag und Bekanntmachung des Hinweises auf die Patenterteilung: **27.08.2025**
(21) Anmeldenummer: 20701039.8
(22) Anmeldetag: 17.01.2020
(51) Int. Cl.: B32B 17/10, B32B 17/06, B32B 15/09, C03C 27/12, H05K 9/00

(54) **VERBUNDSCHEIBE UND VERFAHREN ZU DEREN HERSTELLUNG**
LAMINATED PANE AND METHOD FOR ITS MANUFACTURE
VITRE FEUILLETÉE ET SON PROCÉDÉ DE FABRICATION

(30) Priorität: 21.01.2019 EP 19152806
(43) Veröffentlichungstag der Anmeldung: 01.12.2021
(73) Patentinhaber: Saint-Gobain Sekurit France, 60150 Thourotte (FR)
(72) Erfinder: YATIM, Alexandra, 52072 Aachen (DE); WEBER, Patrick, 52477 Alsdorf (DE); BORHANI HAGHIGHI, Sara, 52070 Aachen (DE)
(74) Vertreter: Gebauer, Dieter Edmund
(86) Internationale Anmeldenummer: PCT/EP2020/051162
(87) Internationale Veröffentlichungsnummer: WO 2020/152057

(56) Entgegenhaltungen:
- EP-A1- 3 117 991
- US-A1- 2007 011 863
- US-A1- 2010 179 725

## Beschreibung

Die Erfindung betrifft eine Verbundscheibe mit mindestens zwei elektrischen Funktionselementen, ein Verfahren zur Herstellung der Verbundscheibe und deren Verwendung.

Verbundscheiben bestehen üblicherweise aus einer Außenscheibe und einer Innenscheibe, die durch eine thermoplastische Zwischenschicht bei Hitze und Druck fest miteinander verbunden werden. Die Zwischenschicht besteht meist aus thermoplastischen Kunststoffen wie Polyvinylbutyral (PVB) oder Ethylenvinylacetat (EVA).

Moderne Fahrzeugverglasungen werden zunehmend mit aktiv steuerbaren elektrischen Funktionselementen versehen, die Informationen anzeigen, als Leuchtmittel dienen oder die optische Transparenz der Scheiben ändern, beispielsweise OLED-Displays (Organic Light Emitting Diods), OLED-Beleuchtungen oder PDLC-Folien (Polymer Dispersed Liquid Crystal). Schon aufgrund des verringerten Platzbedarfs ist es wünschenswert, die elektrischen Funktionselemente durch Lamination in die Verbundscheibe zu integrieren. Werden mehrere elektrische Funktionselemente in einer selben Verbundscheibe eingesetzt, können bei fehlender elektromagnetischer Kompatibilität und einem geringen Abstand der Funktionselemente Störeffekte auftreten. Wie die Erfinder festgestellt haben, kann beispielsweise bei der Integration eines OLED-Displays und einer PDLC-Folie in derselbe Verbundscheibe ein störendes Flackern des Bildes des OLED-Displays verursacht werden. Es wird angenommen, dass feldgebundene Störungen vor allem durch niederfrequente elektromagnetische Störfelder hervorgerufen werden, welche durch Funktionselemente erzeugt werden, die mit Wechselstrom bei einer niedrigen Frequenz im Bereich von beispielsweise 50 bis 60 Hz betrieben werden, beispielsweise PDLC-Folien oder OLED-Beleuchtungen. Diese niederfrequenten elektromagnetischen Störfelder werden in die meist als Flachbandleiter ausgeführte elektrische Anschlussleitung des OLED-Displays eingekoppelt, da sich einlaminierte Flachbandleiter nur schlecht gegen elektromagnetische Störfelder isolieren lassen.

Bisher werden elektromagnetische Kompatibilitätsprobleme gelöst, indem durch diverse elektrische Komponenten wie Spulen, Kondensatoren oder Magnetkerne die Störung an der Störquelle beseitigt wird. Jedoch lassen sich derartige Komponenten nicht in der Verbundscheibe laminieren.

EP 3117991 A1 zeigt eine laminierte Verglasung mit einer IR-reflektierenden Beschichtung, welche dem Schutz von elektrischen Strukturen, wie kapazitive Sensoren, dient.

US 2010/179725 A1 zeigt eine laminierte Verglasung, bei der eine Abschirmung aus einem Metallfilm vorgesehen ist, welche LEDs von einem Schaltbereich abschirmt.

Demnach besteht die Aufgabe der vorliegenden Erfindung darin, eine gegenüber dem Stand der Technik verbesserte Verbundscheibe mit mindestens zwei in die Verbundscheibe laminierten elektrischen Funktionselementen bereitzustellen, bei der elektromagnetische Kompatibilitätsprobleme deutlich verringert oder gänzlich vermieden werden, ohne hierbei auf extern anzuschließende elektrische Bauteile zurückzugreifen. Zudem soll die Verbundscheibe in der industriellen Serienfertigung einfach und kostengünstig herstellbar sein.

Diese und weitere Aufgaben werden nach dem Vorschlag der Erfindung durch eine Verbundscheibe gemäß dem unabhängigen Patentanspruch gelöst. Vorteilhafte Ausgestaltungen der Erfindung ergeben sich aus den Unteransprüchen.

Erfindungsgemäß ist eine Verbundscheibe gezeigt, welche mindestens eine Außenscheibe und eine Innenscheibe umfasst, die durch eine thermoplastische Zwischenschicht fest miteinander verbunden sind. Beim Laminieren der erfindungsgemäßen Verbundscheibe wird eine Stapelfolge aus Außenscheibe, Innenscheibe und einem zwischenliegenden Schichtstapel aus mehreren Einzelschichten laminiert, wobei die thermoplastische Zwischenschicht durch Lamination des Schichtstapels erzeugt wird. Der Begriff "Zwischenschicht" bezieht sich demnach auf eine durch Lamination mehrerer verschiedener Einzelschichten erzeugte Gesamtschicht. Die thermoplastische Zwischenschicht kann insbesondere verschiedene thermoplastische Materialien aufweisen, die auf mehreren Einzelschichten thermoplastischer Materialien basieren.

Die thermoplastische Zwischenschicht enthält mindestens ein erstes (aktives) elektrisches Funktionselement und mindestens ein zweites (aktives) elektrisches Funktionselement, welche somit in der Verbundscheibe laminiert sind. In aller Regel sind jeweilige elektrische Anschlussleitungen der elektrischen Funktionselemente ebenfalls in der Verbundscheibe (teilweise) laminiert. Dies gilt insbesondere für das mindestens eine erste elektrische Funktionselement. Insbesondere handelt es sich bei der elektrischen Anschlussleitung des ersten elektrischen Funktionselements um einen in der Verbundscheibe (teilweise) laminierten Flachbandleiter.

Vorzugsweise ist das mindestens eine erste elektrische Funktionselement in einer separaten Einzelschicht aus thermoplastischem Material eingebettet, welche das erste elektrische Funktionselement rahmenförmig umgibt. Diese separate Einzelschicht aus thermoplastischem Material gleicht den durch das erst elektrische Funktionselement bedingten Höhenunterschied im Innern der Verbundscheibe aus und sorgt für eine verspannungsarme und von optischen Verzerrungen freie Verbindung nach der Lamination.

Gleichermaßen ist das mindestens eine zweite elektrische Funktionselement vorzugsweise in einer separaten Einzelschicht aus thermoplastischem Material eingebettet, welche das zweite elektrische Funktionselement rahmenförmig umgibt. Diese separate Einzelschicht aus thermoplastischem Material gleicht den durch das zweite elektrische Funktionselement bedingten Höhenunterschied im Innern der Verbundscheibe aus und sorgt für eine verspannungsarme und von optischen Verzerrungen freie Verbindung nach der Lamination. Die beiden elektrischen Funktionselemente sind demnach in verschiedenen Einzelschichten enthalten und in Richtung der Stapelfolge voneinander beabstandet.

Im Sinne vorliegender Erfindung ist unter einem "elektrischen Funktionselement" ein aktives elektrisches Bauteil zu verstehen, das steuerbar ist und mit einer elektrischen Versorgungs- bzw. Steuerspannung beaufschlagt wird. Jedes elektrische Funktionselement ist mit einer elektrischen Anschlussleitung versehen, welche einen laminierten Teil umfasst. Im Sinne der Erfindung ist der in der thermoplastischen Zwischenschicht befindliche, laminierte Teil der elektrischen Anschlussleitung des elektrischen Funktionselements ein Bestandteil des elektrischen Funktionselements. Der Begriff "Anschlussleitung" bezeichnet sämtliche elektrische Leiter, an die das elektrische Funktionselement angeschlossen ist.

Das erste elektrische Funktionselement kann mit einer Gleich- oder Wechselspannung gespeist werden. In der Verbundscheibe stellt das erste elektrische Funktionselement (einschließlich des laminierten Teils seiner elektrischen Anschlussleitung) eine Störsenke dar. Bei dem ersten elektrischen Funktionselement handelt es sich um ein OLED-Display, besonders bevorzugt um ein transparentes OLED-Display.

In der erfindungsgemäßen Verbundscheibe wird das zweite elektrische Funktionselement mit einer Wechselspannung gespeist, wobei die Möglichkeit besteht, dass feldgebundene Störungen erzeugt werden, die in die Störsenke eingekoppelt werden können, insbesondere durch die elektrische Anschlussleitung der Störsenke. Typischerweise handelt es sich um eine niederfrequente Wechselspannung, welche eine Frequenz von maximal 100 Hz, insbesondere maximal 80 Hz aufweist, welche beispielsweise im Bereich von 50 bis 60 Hz liegt. Derartige elektromagnetische Störfelder führen beispielsweise zu einem störenden Flackern des OLED-Displays. Dies gilt vor allem dann, wenn die Anschlussleitung des Displays einen einlaminierten Flachbandleiter umfasst, der sich nur schlecht gegen elektromagnetische Störfelder abschirmen lässt. Bei dem zweiten elektrischen Funktionselement handelt es sich um eine OLED-Lichtquelle oder eine PDLC-Folie.

Wesentlich ist, dass in der thermoplastischen Zwischenschicht zwischen dem mindestens einen ersten elektrischen Funktionselement (einschließlich des laminierten Teils seiner Anschlussleitung), im Sinne vorliegender Erfindung die Störsenke, und dem mindestens einen zweiten elektrischen Funktionselement, im Sinne vorliegender Erfindung die Störquelle, eine metallische Schutzschicht angeordnet ist. Die metallische Schutzschicht schirmt die Störsenke vorteilhaft von den von der Störquelle erzeugten Störfeldern ab. Hierbei ist keine vollständige Abschirmung erforderlich, da - wie die Erfinder zeigen konnten - bereits eine teilweise Abschirmung der elektromagnetischen Störfelder visuelle Störungen in einem Display, wie Flackern, wirkungsvoll unterbinden kann. Auf die Verwendung von separaten elektrischen Komponenten zum Zwecke der Entstörung, die nicht-laminiert und somit außerhalb der Verbundscheibe angeordnet sind, kann in vorteilhafter Weise verzichtet werden.

Ein weiterer vorteilhafter Effekt ist die Abschirmung des zwischen metallischer Schutzschicht und Innenscheibe befindlichen mindestens einen elektrischen Funktionselements vor infraroter und ultravioletter Strahlung. Aktive elektrische Funktionselemente sind oftmals empfindlich gegen Hitze und ultraviolette Strahlung.

Eine Degradation elektrischer Funktionselemente kann wirkungsvoll unterbunden werden.

In einer vorteilhaften Ausgestaltung der erfindungsgemäßen Verbundscheibe ist die metallische Schutzschicht transparent für elektromagnetische Strahlung, die für das menschliche Auge sichtbar ist. Eine metallische Schutzschicht ist transparent im Sinne der Erfindung, wenn sie eine Transmission im sichtbaren Spektralbereich von größer 70 %, vorzugsweise größer 80 %, stärker bevorzugt größer 90 %, aufweist. Hierdurch kann einerseits der vorteilhafte Effekt im Hinblick auf eine zumindest teilweise Abschirmung der Störsenke von Störfeldern erreicht werden. Andererseits ist die Durchsicht durch die Verbundscheibe nicht beeinträchtigt.

In einer weiteren vorteilhaften Ausgestaltung der erfindungsgemäßen Verbundscheibe enthält die metallische Schutzschicht mindestens eine Metallschicht, bevorzugt eine Aluminiumschicht, eine Edelstahlschicht, eine Kupferschicht, eine Silberschicht oder eine Goldschicht oder besteht daraus. Derartige Metallschichten sind besonders geeignet, elektromagnetische Störfelder abzuschirmen. Zudem sind sie in der Lage, infrarote oder ultraviolette Strahlung ausreichend zu absorbieren oder zu reflektieren. Besonders vorteilhaft ist dabei eine Aluminiumschicht wegen ihrer guten Wärmeleitfähigkeit und geringen UV-Transmission.

In einer weiteren vorteilhaften Ausgestaltung der erfindungsgemäßen Schutzschicht ist die mindestens eine Metallschicht auf mindestens einer Trägerfolie angeordnet. Die Trägerfolie enthält bevorzugt eine Polymerfolie und insbesondere Polyethylenterephthalat (PET), Polyvinylbutyral (PVB) (beispielsweise Mowital), Ethylen-Vinylacetat (EVA), Polyethylennaphthalat (PEN), Polyepoxid oder Polyimid, oder besteht daraus. Durch die Anordnung einer Metallschicht auf einer Trägerfolie lassen sich auch dünne und spröde Metallschichten gut verarbeiten.

In einer weiteren vorteilhaften Ausgestaltung der erfindungsgemäßen Schutzschicht enthält die Schutzschicht mindestens eine Metallfolie oder besteht daraus. Die Metallfolie ist bevorzugt freitragend, das heißt ausreichend dick und stabil um ohne eine zusätzliche Trägerfolie eingelegt und verarbeitet zu werden. Bevorzugte Metallfolien sind Aluminiumfolien, Edelstahlfolien, Kupferfolien, Silberfolien oder Goldfolien. Es versteht sich, dass auch mehrere Metallfolien miteinander kombiniert werden können, beispielsweise um eine optimierte Undurchlässigkeit für infrarote und ultraviolette Strahlung zu erzielen.

In einer weiteren vorteilhaften Ausgestaltung weist die Metallschicht eine Dicke von 0,5 µm bis 500 µm, bevorzugt von 1 µm bis 200 µm, insbesondere von 20 µm bis 50 µm auf. Derartig dicke Metallschichten können elektromagnetische Störfelder gut abschirmen und weisen eine ausreichend gute Undurchlässigkeit für infrarote und/oder ultraviolette Strahlung auf. Des Weiteren sind derartige Metallschichten kostengünstig und gut zu verarbeiten.

Die metallische Schutzschicht kann in Form einer beschichteten Trägerfolie oder Metallfolie in die Stapelfolge der Verbundscheibe eingelegt und laminiert werden.

In einer Ausgestaltung der erfindungsgemäßen Verbundscheibe ist jedes elektrische Funktionselement abschnittsweise zwischen der Außenscheibe und der Innenscheibe angeordnet. Abschnittsweise bedeutet hier, dass das elektrische Funktionselement in der orthogonalen Projektion auf die Außen- oder Innenscheibe (senkrechte Sicht in Richtung der Stapelfolge auf die Außen- bzw. Innenscheibe) nicht die volle Fläche der Außenscheibe oder Innenscheibe bedeckt, sondern nur einen Teilbereich, wie einen schmalen bandförmigen Streifen.

Dementsprechend ist gemäß einer Ausgestaltung der erfindungsgemäßen Verbundscheibe die metallische Schutzschicht nur abschnittsweise zwischen der Außenscheibe und der Innenscheibe angeordnet. Abschnittsweise bedeutet hier, dass die metallische Schutzschicht in der orthogonalen Projektion auf die Außen- oder Innenscheibe (senkrechte Sicht in Richtung der Stapelfolge auf die Außen- bzw. Innenscheibe) nicht die volle Fläche der Außenscheibe oder der Innenscheibe bedeckt, sondern nur einen Teilbereich, wie einen schmalen bandförmigen Streifen.

Falls sich das mindestens eine erste elektrische Funktionselement zwischen metallischer Schutzschicht und Außenscheibe befindet (Fall I), ist es erfindungsgemäß bevorzugt, wenn ein Bereich der orthogonalen Projektion des mindestens einen ersten elektrischen Funktionselement (einschließlich des laminierten Teils von dessen elektrischer Anschlussleitung) auf die Außenscheibe vollständig im Bereich der orthogonalen Projektion der metallischen Schutzschicht auf die Außenscheibe angeordnet ist.

Falls sich das mindestens eine erste elektrische Funktionselement zwischen metallischer Schutzschicht und Innenscheibe befindet (Fall II), ist es erfindungsgemäß bevorzugt, wenn ein Bereich der orthogonalen Projektion des mindestens einen ersten elektrischen Funktionselement (einschließlich des laminierten Teils von dessen elektrischer Anschlussleitung) auf die Innenscheibe vollständig im Bereich der orthogonalen Projektion der metallischen Schutzschicht auf die Innenscheibe angeordnet ist.

Die orthogonale Projektion der metallischen Schutzschicht auf die Außen- bzw. Innenscheibe ergibt sich bei senkrechter Sicht durch die metallische Schutzschicht (senkrecht zur Ebene der metallischen Schutzschicht, d.h. in Richtung der Stapelfolge). Hierdurch kann eine gute Abschirmung der Störsenke vor elektromagnetischer Störstrahlung erzielt werden.

Besonders bevorzugt beträgt der Bereich der orthogonalen Projektion der metallischen Schutzschicht auf die Außen- bzw. Innenscheibe mindestens 90%, insbesondere 100%, der Fläche der das mindestens eine erste elektrische Funktionselement enthaltenden Ebene der thermoplastischen Zwischenschicht. Die das mindestens eine erste elektrische Funktionselement enthaltende Ebene der thermoplastischen Zwischenschicht ist parallel zur Außen- bzw. Innenscheibe. Hierdurch kann eine besonders wirksame Abschirmung der Störsenke vor elektromagnetischen Störfeldern erreicht werden.

Bei einer besonders vorteilhaften Ausgestaltung der erfindungsgemäßen Verbundscheibe weist die thermoplastische Zwischenschicht zwischen dem mindestens einen ersten elektrischen Funktionselement und dem mindestens einen zweiten elektrischen Funktionselement eine dickere Einzelschicht aus einem thermoplastischen Material auf, die als "Spacer" bzw. Abstandshalter zur Beabstandung des mindestens einen ersten elektrischen Funktionselements und des mindestens einen zweiten elektrischen Funktionselements dient. Vorteilhaft wird zu diesem Zweck in die Stapelfolge der thermoplastischen Schicht vor Lamination eine Folie aus thermoplastischem Material eingefügt, die eine Dicke von mindestens 0,1 mm, vorzugsweise mindestens 0,30 mm, aufweist. Hierdurch kann in vorteilhafter Weise eine Abschwächung der Wirkung der von der Störquelle erzeugten elektromagnetischen Störfelder durch größeren Abstand zur Störsenke erreicht werden.

Als Außenscheibe und Innenscheibe sind im Grunde alle elektrisch isolierenden Substrate geeignet, die unter den Bedingungen der Herstellung und der Verwendung der erfindungsgemäßen Verbundscheibe thermisch und chemisch stabil sowie dimensionsstabil sind.

Die Scheiben enthalten bevorzugt Glas, besonders bevorzugt Flachglas, ganz besonders bevorzugt Floatglas, wie Kalk-Natron-Glas, Borosilikatglas oder Quarzglas, oder bestehen daraus. Alternativ können die Scheiben klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon enthalten oder daraus bestehen. Die Scheiben sind bevorzugt transparent, insbesondere für die Verwendung der Scheiben als Windschutzscheibe oder Rückscheiben eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer 70 % aufweist. Für Scheiben, die nicht im verkehrsrelevanten Sichtfeld des Fahrers liegen, beispielsweise für Dachscheiben, kann die Transmission aber auch viel geringer sein, beispielsweise größer als 5 %.

Die Dicke der Scheiben kann breit variieren und so den Erfordernissen des Einzelfalls angepasst werden. Vorzugsweise werden Standardstärken der einzelnen Scheiben von 1,0 mm bis 25 mm, bevorzugt von 1,4 mm bis 2,5 mm für Fahrzeugglas und bevorzugt von 4 mm bis 25 mm für Möbel, Geräte und Gebäude, insbesondere für elektrische Heizkörper, verwendet. Die Größe der Scheiben kann breit variieren und richtet sich nach der Größe der erfindungsgemäßen Verwendung. Die erste Scheibe und zweite Scheibe weisen beispielsweise im Fahrzeugbau und Architekturbereich übliche Flächen von 200 cm² bis zu 20 m² auf.

Die Verbundscheibe kann eine beliebige dreidimensionale Form aufweisen. Vorzugsweise hat die dreidimensionale Form keine Schattenzonen, so dass sie beispielsweise durch Kathodenzerstäubung beschichtet werden kann, beispielsweise mit einer flächigen Infrarot-reflektierenden Beschichtung oder einer Low-E-Beschichtung. Bevorzugt sind die Scheiben planar oder leicht oder stark in einer Richtung oder in mehreren Richtungen des Raumes gebogen. Insbesondere werden planare Substrate verwendet. Die Scheiben können farblos oder gefärbt sein.

Die thermoplastische Zwischenschicht enthält mindestens einen Kunststoff, bevorzugt Polyvinylbutyral (PVB), Ethylenvinylacetat (EVA) und/oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die thermoplastische Zwischenschicht kann durch eine oder auch durch mehrere übereinander angeordnete Folien ausgebildet werden, wobei die Dicke einer Folie bevorzugt von 0,025 mm bis 1 mm beträgt, typischerweise 0,38 mm oder 0,76 mm. Die Einzelschichten der thermoplastischen Zwischenschichten können thermoplastisch sein und nach der Lamination der Scheiben miteinander verkleben.

Die Begriffe "Außenscheibe" und "Innenscheibe" sind lediglich zur Unterscheidung der beiden Scheiben bei einer erfindungsgemäßen Verbundscheibe gewählt. Mit den Begriffen ist keine Aussage über die geometrische Anordnung verbunden. Ist die erfindungsgemäße Verbundscheibe beispielsweise dafür vorgesehen, in einer Öffnung, beispielsweise eines Fahrzeugs oder eines Gebäudes, den Innenraum gegenüber der äußeren Umgebung abzutrennen, so ist die Außenscheibe in der Regel der äußeren Umgebung zugewandt, wohingegen die Innenscheibe dem Innenraum zugewandt ist.

Gemäß einer Ausgestaltung der Erfindung umfasst die thermoplastische Zwischenschicht zumindest vor Lamination eine oder mehrere der folgenden Merkmale:
- eine Einzelschicht aus einem thermoplastischen Material, welche das mindestens eine erste elektrische Funktionselement enthält, insbesondere rahmenförmig umgibt;
- eine Einzelschicht aus einem thermoplastischen Material, welche das mindestens eine zweite elektrische Funktionselement enthält, insbesondere rahmenförmig umgibt, wobei die das zweite elektrische Funktionselement enthaltende Einzelschicht von der das erste elektrische Funktionselement enthaltenden Einzelschicht verschieden ist;
- eine Einzelschicht aus einem thermoplastischen Material, welche eine seitlich aus der Verbundscheibe geführte Anschlussleitung, insbesondere einen Flachbandleiter, enthält, wobei die Anschlussleitung mit dem mindestens einen ersten elektrischen Funktionselement elektrisch verbunden ist, und wobei die Einzelschicht aus einem thermoplastischen Material von den Einzelschichten, die das erste bzw. zweite elektrische Funktionselement enthalten, verschieden ist;
- zwischen den beiden elektrischen Funktionselementen mindestens eine metallische Schutzschicht, welche vorzugsweise transparent für sichtbares Licht ist;
- beidseitig der metallischen Schutzschicht, vorzugsweise beidseitig einer die metallische Schutzschicht bildenden Metallfolie oder einer Trägerfolie mit einer metallischen Schutzschicht, jeweils eine Einzelschicht aus einem thermoplastischen Material; die zwischen der metallischen Schutzschicht und der Störsenke befindliche Einzelschicht aus einem thermoplastischen Material ist vorzugsweise dick, mit einer Schichtdicke von wenigstens 0,1 mm, vorzugsweise wenigstens 0,3 mm, um eine größere Beabstandung der Störsenke von der Störquelle zu erreichen;
- unmittelbar angrenzend an die Innenscheibe eine optionale Einzelschicht aus einem thermoplastischen Material;
- unmittelbar angrenzend an die Außenscheibe eine optionale Einzelschicht aus einem thermoplastischen Material.

Die thermoplastischen Materialien der Einzelschichten können gleich oder voneinander verschieden sein. Die Zwischenschicht kann insbesondere durch mehrere Folien, die flächenmäßig oder abschnittsweise übereinander angeordnet werden, ausgebildet werden. Falls Einzelschichten aus gleichen Materialien bestehen, sind sie gegebenenfalls nach Lamination nicht mehr individualisierbar.

Die Erfindung erstreckt sich weiterhin auf ein Verfahren zur Herstellung einer wie oben beschrieben ausgebildeten, erfindungsgemäßen Verbundscheibe, welches die folgenden Schritte umfasst:
(a) Herstellen einer Stapelfolge aus einer Außenscheibe, einer mehrere verschiedene Einzelschichten enthaltenden thermoplastischen Zwischenschicht und einer Innenscheibe,
(b) Laminieren der Stapelfolge zu einer Verbundscheibe.

Das Verbinden der Stapelfolge in Verfahrensschritt (b) erfolgt bevorzugt unter Einwirkung von Hitze, Vakuum und/oder Druck. Es können an sich bekannte Verfahren zur Herstellung einer Verbundscheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80°C bis 110 °C. Die Außenscheibe, die thermoplastische Zwischenschicht und die Innenscheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die Scheiben innerhalb von beispielsweise etwa 60 Minuten bei verminderten Drücken von 0,01 mbar bis 800 mbar und Temperaturen von 80°C bis 170°C laminiert werden.

Ferner erstreckt sich die Erfindung auf die Verwendung der erfindungsgemäßen Verbundscheibe in Gebäuden, insbesondere im Zugangsbereich, Fensterbereich, Dachbereich oder Fassadenbereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seitenscheibe und/oder Dachscheibe.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird nachfolgend anhand eines Ausführungsbeispiels näher erläutert, wobei Bezug auf die beigefügten Figuren genommen wird. Es zeigen in vereinfachter, nicht maßstabsgetreuer Darstellung:
- Figur 1: eine Draufsicht auf eine Ausgestaltung der erfindungsgemäßen Verbundscheibe,
- Figur 2: eine Querschnittsansicht der Verbundscheibe entlang der Schnittlinie A-A aus Figur 1,
- Figur 3: ein detailliertes Flussdiagramm einer Ausführungsform des erfindungsgemäßen Verfahrens zur Herstellung der Verbundscheibe.

### Ausführliche Beschreibung der Zeichnungen

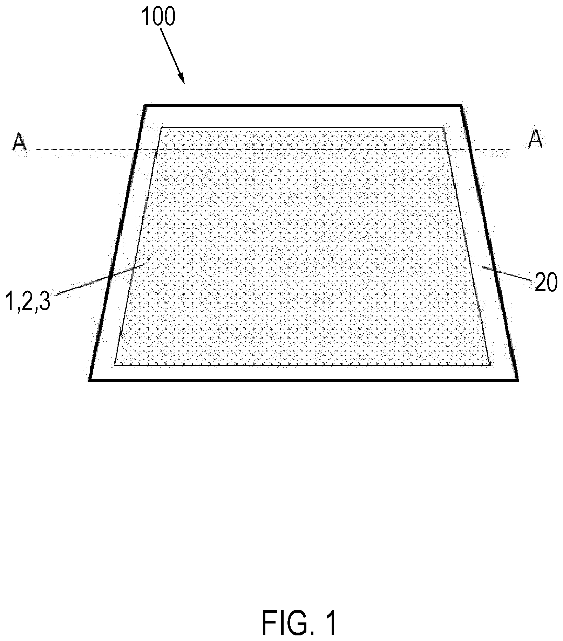

Figur 1 zeigt eine Draufsicht auf eine beispielhafte Ausgestaltung einer erfindungsgemäßen Verbundscheibe 100 mit laminierten elektrischen Funktionselementen. Die Verbundscheibe 100 dient hier beispielsweise als Fahrzeugscheibe, insbesondere als Windschutzscheibe eines Personenkraftwagens. Entsprechend der typischen Form von Windschutzscheiben ist die Verbundscheibe 100 beispielsweise im Wesentlichen trapezförmig. Die Abmessungen der Verbundscheibe 100 betragen an ihren langen Seiten beispielsweise 0,9 m x 1,5 m. Generell kann die Verbundscheibe 100 mit entsprechender Formgebung auch in anderen Anwendungen eingesetzt werden, beispielsweise als Bauverglasung, Mobiliarverglasung oder ähnliches. Denkbar ist auch, dass die Verbundscheibe 100 Teil einer Isolierverglasung ist und beispielsweise in einem Fenster eines Gebäudes angeordnet ist. Alternativ kann die Verbundscheibe 100 auch in einem Innenraum angeordnet sein und beispielsweise eine Verglasung eines Besprechungsraums oder eines Kühlgeräts oder Möbelstücks sein.

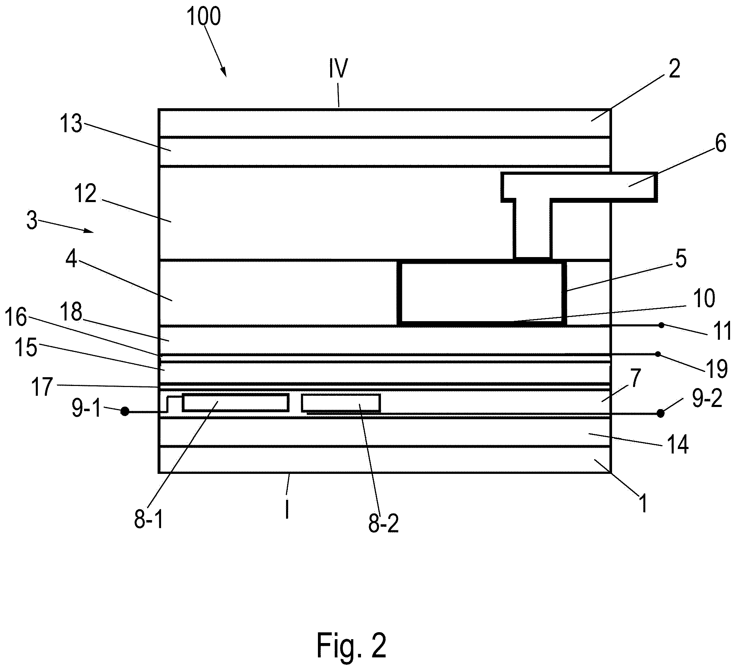

In Figur 2 ist eine Querschnittsansicht der Verbundscheibe 100 entlang der Schnittlinie A-A aus Figur 1 gezeigt. Die Verbundscheibe 100 umfasst eine Außenscheibe 1 und eine Innenscheibe 2, die über eine insgesamt mit der Bezugszahl 3 bezeichnete thermoplastische Zwischenschicht fest miteinander verbunden sind. Die thermoplastische Zwischenschicht 3 setzt sich aus einer Mehrzahl von Einzelschichten zusammen, die über- bzw. untereinanderliegend angeordnet und jeweils vollflächig ausgebildet sind, d.h. in senkrechter Projektion (senkrechte Sicht in Stapelfolge) auf die Außenscheibe 1 oder Innenscheibe 2 haben alle Einzelschichten dieselbe Fläche. Die thermoplastische Zwischenschicht 3 erstreckt sich über den kompletten Bereich zwischen Außenscheibe 1 und Innenscheibe 3.

Die Innenscheibe 2 ist dafür vorgesehen, in Einbaulage dem Innenraum eines Fahrzeugs zugewandt zu sein. Das heißt, die außenseitige Oberfläche IV der Innenscheibe 2 ist vom Innenraum aus zugänglich, wogegen die außenseitige Oberfläche I der Außenscheibe 1 bezüglich des Fahrzeuginnenraums nach außen weist. Die Begriffe innenseitig und außenseitig beziehen sich jeweils auf die Innen- und Außenseite der Verbundscheibe 100. Die Außenscheibe 1 und die Innenscheibe 2 bestehen jeweils aus Glas, hier beispielsweise aus Natron-Kalkglas. Die Dicke der Innenscheibe 2 beträgt beispielsweise 1,6 mm und die Dicke der Außenscheibe 1 beträgt beispielsweise 2,1 mm. Es versteht sich, dass Außenscheibe 1 und Innenscheibe 2 auch aus einem anderen Glasmaterial bestehen, beliebige Dicken aufweisen und beispielsweise auch gleich dick ausgebildet sein können.

Die einzelnen Komponenten der Verbundscheibe 100, insbesondere die innerhalb der thermoplastischen Zwischenschicht 3 angeordneten elektrischen Funktionselemente, sind in der Schnittansicht von Figur 2 deutlich zu erkennen. Die thermoplastische Zwischenschicht 3 umfasst eine Mehrzahl von Schichten, die jeweils thermoplastisches Material enthalten, hier beispielsweise PVB. Diese Schichten werden zur leichteren Bezugnahme im Weiteren vereinfacht als "PVB-Schichten" bezeichnet. Die PVB-Schichten können verschiedene Zusammensetzungen von PVB enthalten. Es versteht sich, dass die PVB-Schichten anstatt PVB ein von PVB verschiedenes thermoplastisches Material enthalten können, welches zum Laminieren der Außenscheibe 1 und Innenscheibe 2 geeignet ist.

Die Verbundscheibe 100 umfasst mehrere elektrische Funktionselemente, die in verschiedenen PVB-Schichten des Schichtenstapels 3 angeordnet sind. Die elektrischen Funktionselemente werden jeweils mit Steuersignalen und einer Versorgungsspannung beaufschlagt.

In einer ersten PVB-Schicht 4 ist ein erstes elektrisches Funktionselement angeordnet, bei dem es sich hier beispielsweise um ein OLED-Display 5 handelt. Das OLED-Display 5 ist zur Übertragung von Steuersignalen und zur Spannungsversorgung mit einer Anschlussleitung, im Weiteren als "OLED-Display-Anschlussleitung 6" bezeichnet, versehen. Die OLED-Display-Anschlussleitung 6 ist hier als Flachbandleiter ausgeführt. Das OLED-Display 5 wird mit einer Wechselspannung betrieben.

In einer zweiten PVB-Schicht 7 ist mindestens ein zweites elektrisches Funktionselement angeordnet, das mit einer niederfrequenten Wechselspannung im Bereich von maximal 60 Hz, beispielsweise 50 bis 60 Hz, betrieben wird. Im vorliegenden Ausführungsbeispiel sind zwei zweite elektrische Funktionselemente dargestellt, nämlich eine PDLC-Folie 8-1 und eine OLED-Beleuchtung 8-2, von denen eines oder beide in der Verbundscheibe 100 angeordnet sein können. Die PDLC-Folie 8-1 ist zur Übertragung von Steuersignalen und zur Spannungsversorgung mit einer elektrischen Anschlussleitung, im Weiteren als "PDLC-Folie-Anschlussleitung 9-1" bezeichnet, elektrisch verbunden. Gleichermaßen ist die OLED-Beleuchtung 8-2 zur Übertragung von Steuersignalen und zur Spannungsversorgung mit einer elektrischen Anschlussleitung, im Weiteren als "OLED-Beleuchtung-Anschlussleitung 9-2" bezeichnet, elektrisch verbunden. Die beiden zweiten elektrischen Funktionselemente 8-1, 8-2 sind hier beispielsweise in einer selben PVB-Schicht enthalten, wobei sie gleichermaßen in voneinander verschiedenen PVB-Schichten angeordnet sein können.

Das OLED-Display 5 ist in die erste PVB-Schicht 4 eingebettet, welche das OLED-Display 5 rahmenförmig umgibt. Die erste PVB-Schicht 4 ist transparent und hat beispielsweise eine Dicke von 0,51 mm, was wenigstens der Dicke des OLED-Displays 5 entspricht und ein passgenaues Laminieren des OLED-Displays 5 innerhalb der ersten PVB-Schicht 4 ermöglicht. Das OLED-Display 5 ist an seiner Rückseite 10 passiv geerdet. Es besitzt einen optional nutzbaren elektrischen Massenanschluss, im Weiteren als "OLED-Display-Massenanschluss 11" bezeichnet, durch den eine aktive Erdung des OLED-Displays 5 möglich ist. Der OLED-Display-Massenanschluss 10 ist seitlich aus der Verbundscheibe 100 herausgeführt.

Die beiden zweiten elektrischen Funktionselemente 8-1, 8-2 sind in der zweiten PVB-Schicht 7 nebeneinander liegend eingebettet, wobei die zweite PVB-Schicht 7 die beiden zweiten elektrischen Funktionselemente 8-1, 8-2 jeweils rahmenförmig umgibt. Alternativ ist nur ein zweites elektrisches Funktionselement vorhanden, welches von der zweiten PVB-Schicht 7 rahmenförmig umgeben wird. Die zweite PVB-Schicht 7 ist transparent und hat beispielsweise eine Dicke von 0,38 mm, was wenigstens der Dicke der PDLC-Folie 8-1 und der Dicke der OLED-Beleuchtung 8-2 entspricht, so dass die beiden zweiten elektrischen Funktionselemente 8-1, 8-2 passgenau in der zweiten PVB-Schicht 7 laminiert werden können. Die PDLC-Folie 8-1 weist zur Übertragung von Steuersignalen und zur Spannungsversorgung eine elektrische Anschlussleitung, im Weiteren als "PDLC-Folie-Anschlussleitung 9-1" bezeichnet, auf. Gleichermaßen weist die OLED-Beleuchtung 8-2 zur Übertragung von Steuersignalen und Spannungsversorgung eine elektrische Anschlussleitung, im Weiteren als "OLED-Beleuchtung-Anschlussleitung 9-2" bezeichnet, auf. Die PDLC-Folie-Anschlussleitung 9-1 und die OLED-Beleuchtung-Anschlussleitung 9-2 sind jeweils seitlich aus der Verbundscheibe 100 herausgeführt.

Der ersten PVB-Schicht 4 unmittelbar anliegend und zwischen der ersten PVB-Schicht 4 und der Innenscheibe 2 angeordnet, ist eine dritte PVB-Schicht 12 vorgesehen. In die dritte PVB-Schicht 12 ist das OLED-Display-Anschlusskabel 6 eingebettet und seitlich aus der Verbundscheibe 100 herausgeführt. Die dritte PVB-Schicht 12 ist transparent und hat beispielsweise eine Dicke von 0,84 mm, was wenigstens der Abmessung des OLED-Display-Anschlusskabels 6 entlang der Stapelfolge des Schichtstapels 3 entspricht, so dass das OLED-Display-Anschlusskabel 6 passgenau in der dritten PVB-Schicht 12 laminiert werden kann. Der Innenscheibe 2 unmittelbar anliegend und zwischen der dritten PVB-Schicht 14 und der Innenscheibe 2 angeordnet, ist eine vierte PVB-Schicht 13 vorgesehen. Der Außenscheibe 1 unmittelbar anliegend und zwischen der zweiten PVB-Schicht 7 und der Außenscheibe 1 angeordnet, ist eine fünfte PVB-Schicht 14 vorgesehen. Die vierte PVB-Schicht 13 und die fünfte PVB-Schicht 14 sind jeweils transparent und haben jeweils beispielsweise eine Dicke von 0,38 mm. Die vierte PVB-Schicht 13 und die fünfte PVB-Schicht 14 erfüllen die gesetzlichen Richtlinien an Verbundscheiben bzgl. Bruchsicherheit und Splitterbindung. Im Falle eines Bruches bleiben die entstehenden Glassplitter an diesen PVB-Schichten haften und können nicht in den Innenraum des Fahrzeugs gelangen, wo etwaige Glassplitter schwere Verletzungen verursachen können. Auf die vierte PVB-Schicht 13 und die fünfte PVB-Schicht 14 kann verzichtet werden, falls die Gesamtflächen der elektrischen Funktionselemente im Verhältnis zu Gesamtglasfläche relativ niedrig ist (maximal 5 % der Gesamtglasfläche) und die elektrischen Funktionselemente nicht am Rand angeordnet sind (mehr als 1 cm Abstand vom Rand). Die vierte PVB-Schicht 13 dient auch als Verbindungsschicht zwischen dem OLED-Display-Anschlusskabel 6 und der Innenscheibe 2. In entsprechender Weise dient auch die fünfte PVB-Schicht 14 als Verbindungsschicht zwischen der PDLC-Folie-Anschlussleitung 9-1 und der OLED-Beleuchtung-Anschlussleitung 9-2 und der Außenscheibe 1.

Zwischen der das OLED-Display 5 enthaltenden ersten PVB-Schicht 4 und der die PDLC-Folie 8-1 und/oder die OLED-Beleuchtung 8-2 enthaltenden zweiten PVB-Schicht 7 befindet sich eine PET-Folie 15, die auf einer Seite, hier beispielsweise die der Innenscheibe 2 zugewandten Seite, mit einer metallischen Schutzschicht 16 aus einem metallischen Material beschichtet ist. Unmittelbar angrenzend an die metallische Schutzschicht 16 und zwischen der metallischen Schicht 16 und der ersten PVB-Schicht 4 befindet sich eine sechste PVB-Schicht 18, die analog zur vierten PVB-Schicht 13 bzw. fünften PVB-Schicht 14 aufgebaut ist. Unmittelbar angrenzend an die PET-Folie 15 und zwischen der PET-Folie 15 und der zweiten PVB-Schicht 7 befindet sich eine siebte PVB-Schicht 17, die transparent und beispielsweise 0,05 mm dick ist. Die sechste PVB-Schicht 18 und die siebte PVB-Schicht 17 dienen jeweils zum beidseitigen Laminieren der PET-Folie 15 mit der darauf aufgebrachten metallischen Schutzschicht 16. In Sicht senkrecht durch die Stapelfolge erstreckt sich die metallische Schutzschicht 16 über die komplette Abmessung sowohl der das OLED-Display 5 enthaltenden ersten PVB-Schicht 4 als auch der die PDLC-Folie 8-1 und die OLED-Beleuchtung 8-2 enthaltenden zweiten PVB-Schicht 7. Alternativ wäre es möglich, dass sich die metallische Schutzschicht 16 über eine kleinere Fläche erstreckt, wobei es aber im Hinblick auf die unten beschriebene Funktion bevorzugt ist, wenn sich die metallische Schutzschicht 16 wenigstens über eine Fläche erstreckt, die 90% der Fläche der das OLED-Display 5 enthaltenden ersten PVB-Schicht 4 ausmacht. Die auf die PET-Folie 15 aufgebrachte metallische Schutzschicht 16 ist elektrisch leitfähig, transparent und hat beispielsweise eine Dicke von 0,05 mm. Als Materialien für die metallische Schutzschicht 16 kommen im Grunde alle elektrisch leitenden Metalle in Frage, wie Aluminium, Edelstahl, Kupfer oder Gold, insbesondere Silber. Vorzugsweise ist die metallische Schutzschicht 16 transparent für sichtbares Licht.

Die metallische Schutzschicht 16 ist passiv geerdet, kann optional aber auch aktiv geerdet werden. Die metallische Schutzschicht 16 verfügt zu diesem Zweck über einen Schutzschicht-Massenanschluss 19. Der Schutzschicht-Massenanschluss 19 ist vorzugsweise mit dem rückseitigen OLED-Display-Massenanschluss 11 elektrisch verbunden.

In der Verbundscheibe 100 werden die PDLC-Folie 8-1 und die OLED-Beleuchtung 8-2 typischer Weise mit einer niederfrequenten Wechselspannung mit einer Frequenz im Bereich von beispielsweise 50 bis 60 Hz und einer Wechselspannung im Bereich von 36 bis 100 V betrieben. Hierdurch werden niederfrequente elektromagnetische Störfelder erzeugt, die über das OLED-Display-Anschlusskabel 6 in das OLED-Display 5 eingekoppelt werden können und dort ein für den Betrachter störend wahrnehmbares Flackern der Anzeige erzeugen. Die PDLC-Folie 8-1 und die OLED-Beleuchtung 8-2 stellen somit niederfrequente elektromagnetische Störquellen dar. Das OLED-Display 5 ist eine Störsenke, die vor allem über das OLED-Display-Anschlusskabel 6 mit den Störquellen gekoppelt ist.

Durch die zwischen den beiden Störquellen und dem OLED-Display 5 befindliche metallische Schutzschicht 16 kann das OLED-Display 5 von den elektromagnetischen Störfeldern zumindest weitestgehend abgeschirmt werden, so dass ein unangenehmes Flackern oder andere Störungen des OLED-Displays 5 reduziert oder gänzlich vermieden werden. Die metallische Schutzschicht 16 kann diese Aufgabe gegebenenfalls bereits ohne Verbindung mit elektrischer Masse erreichen. Wird die metallische Schutzschicht 16 aktiv geerdet, indem beispielsweise der rückseitige OLED-Display-Massenanschluss 11 und der Schutzschicht-Massenanschluss 19 elektrisch miteinander verbunden werden, kann die Abschirmung von elektromagnetischen Störfeldern noch weiter verbessert werden.

In dieser Hinsicht vorteilhaft ist auch eine Vergrößerung des Abstands zwischen Störquellen und Störsenke. Eine Vergrößerung des Abstands zwischen den beiden zweiten elektrischen Funktionselementen (PDLC-Folie 8-1 und OLED-Beleuchtung 8-2) und dem ersten elektrischen Funktionselement (OLED-Display 5) kann in einfacher Weise durch die relativ dicke siebte PVB-Schicht 18 (hier beispielsweise 0,38 mm) erreicht werden. Durch diese Maßnahme kann die Abschirmung des OLED-Displays 5 von elektromagnetischen Störfeldern, die von der PDLC-Folie 8-1 und OLED-Beleuchtung 8-2 erzeugt werden, noch weiter verbessert werden.

Ein weiterer Vorteil der metallischen Schutzschicht 16 ist ein Schutz des OLED-Displays 5 vor durch Infrarotstrahlung verursachte Erwärmung und ultravioletter Strahlung, da infrarote und ultraviolette Anteile der Sonnenstrahlung von der metallischen Schutzschicht 16 großteils reflektiert werden können. Zudem kann der Energieeintrag in den Fahrzeuginnenraum verringert werden.

Die Außenscheibe 1, die Innenscheibe 2 und die verschiedenen Schichten der thermoplastischen Schutzschicht 3 können bei der Fertigung der Verbundscheibe 100 in einem Laminierprozess dauerhaft fest miteinander verbunden.

In Figur 1 ist ergänzend eine Randabdeckung 20 gezeigt, welche beispielsweise in Form eines Schwarzdrucks ausgebildet ist.

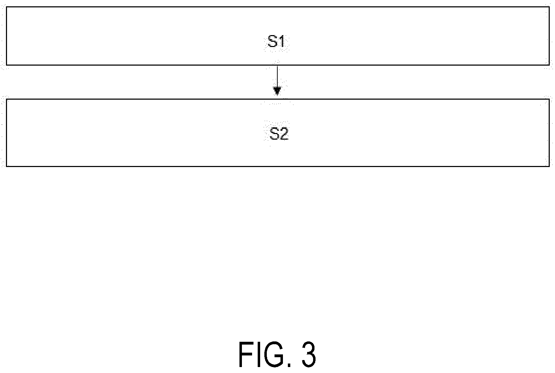

Ein konkretes Herstellungsverfahren zur Herstellung der oben beschriebenen Verbundscheibe 100 geht aus dem Flussdiagramm von Figur 3 hervor. Es umfasst die folgenden Verfahrensschritte S1-S2:
S1: Bereitstellen einer Stapelfolge, enthaltend
   - eine Außenscheibe 1,
   - optional eine vierte PVB-Schicht 13,
   - eine dritte PVB-Schicht 12, in welche eine OLED-Display-Anschlussleitung 6 eingebettet ist,
   - eine erste PVB-Schicht 4, die rahmenförmig um ein OLED-Display 5, angeordnet ist;
   - eine siebte PVB-Schicht 18,
   - eine PET-Folie 15 mit einer metallischen Schutzschicht 16,
   - eine sechste PVB-Schicht 17,
   - eine zweite PVB-Schicht 7, die rahmenförmig um die PDLC-Folie 8-1 und/oder OLED-Beleuchtung 8-2, angeordnet ist;
   - eine metallische Schutzschicht 18 zwischen der ersten PVB-Schicht 4 und der zweiten PVB-Schicht;
   - eine zweite PVB-Schicht 7, die rahmenförmig um eine PDLC-Folie 8-1 und/oder um eine OLED-Beleuchtung 8-1 angeordnet ist;
   - optional eine fünfte PVB-Schicht 14,
   - eine Innenscheibe 2
S2: Laminieren der Stapelfolge zu einer Verbundscheibe 100.

Die vorliegende Erfindung stellt eine verbesserte Verbundscheibe mit integrierten elektrischen Funktionselementen zur Verfügung, bei der eine von einem ersten elektrischen Funktionselement gebildete Störsenke durch eine metallische Schutzschicht von feldgebundenen Störungen, die durch mindestens ein zweites elektrisches Funktionselement (Störquelle) erzeugt werden, abgeschirmt wird. Auf aufwändige elektrische Komponenten außerhalb der Verbundscheibe kann verzichtet werden.

### Bezugszeichenliste

- 1: Außenscheibe
- 2: Innenscheibe
- 3: Zwischenschicht
- 4: erste PVB-Schicht
- 5: OLED-Display
- 6: OLED-Display-Anschlussleitung
- 7: zweite PVB-Schicht
- 8-1: PDLC-Folie
- 8-2: OLED-Beleuchtung
- 9-1: PDLC-Folie-Anschlussleitung
- 9-2: OLED-Beleuchtung-Anschlussleitung
- 10: Rückseite des OLED-Displays 5
- 11: OLED-Display-Massenanschluss
- 12: dritte PVB-Schicht
- 13: vierte PVB-Schicht
- 14: fünfte PVB-Schicht
- 15: PET-Folie
- 16: Schutzschicht
- 17: sechste PVB-Schicht
- 18: siebte PVB-Schicht
- 19: Schutzschicht-Massenanschluss
- 20: Abdeckung
- 100: Verbundscheibe

## Patentansprüche

1. Verbundscheibe (100), umfassend:
eine Außenscheibe (1) und eine Innenscheibe (2), die durch mindestens eine thermoplastische Zwischenschicht (3) fest miteinander verbunden sind, wobei die Zwischenschicht (3) mindestens ein erstes elektrisches Funktionselement (5) und mindestens ein durch eine Wechselspannung gespeistes zweites elektrisches Funktionselement (8-1, 8-2) aufweist, wobei zwischen den beiden elektrischen Funktionselementen (5, 8-1, 8-2) mindestens eine metallische Schutzschicht (16) zur Abschirmung von vom zweiten elektrischen Funktionselement (8-1, 8-2) erzeugten feldgebundenen Störungen angeordnet ist,
wobei das mindestens eine erste elektrische Funktionselement ein OLED-Display und das mindestens eine zweite elektrische Funktionselement eine PDLC-Folie (8-1) und/oder eine OLED-Lichtquelle ist.

2. Verbundscheibe (100) nach Anspruch 1, bei welcher die metallische Schutzschicht (16) mindestens eine Metallschicht, bevorzugt eine Aluminiumschicht, eine Edelstahlschicht, eine Kupferschicht, eine Silberschicht oder eine Goldschicht enthält oder daraus besteht.

3. Verbundscheibe (100) nach Anspruch 1, bei welcher die metallische Schutzschicht (16) auf einer Trägerfolie (15) angeordnet ist, insbesondere eine polymere Trägerfolie, welche beispielsweise Polyethylenterephthalat (PET), Polyvinylbutyral (PVB), Ethylen-Vinylacetat (EVA), Polyethylennaphthalat (PEN), Polyepoxid oder Polyimid enthält oder daraus besteht.

4. Verbundscheibe (100) nach einem der Ansprüche 1 bis 3, bei welcher die metallische Schutzschicht (16) eine Metallfolie, insbesondere eine Aluminiumfolie, eine Edelstahlfolie, eine Kupferfolie, eine Silberfolie oder eine Goldfolie enthält oder daraus besteht.

5. Verbundscheibe (100) nach einem der Ansprüche 1 bis 4, bei welcher die metallische Schutzschicht (16) eine Dicke von 0,5 µm bis 500 µm, insbesondere von 1 µm bis 200 µm und insbesondere von 20 µm bis 50 µm aufweist, wobei die metallische Schutzschicht (16) vorzugsweise transparent für vom menschlichen Auge sichtbares Licht ist.

6. Verbundscheibe (100) nach einem der Ansprüche 1 bis 5, bei welcher
(i) falls sich das mindestens eine erste elektrische Funktionselement (5) zwischen der metallischen Schutzschicht (16) und der Außenscheibe (1) befindet, eine Fläche der orthogonalen Projektion der metallischen Schutzschicht (16) auf die Außenscheibe (1) mindestens 90% einer Fläche der orthogonalen Projektion einer das mindestens eine erste Funktionselement (5) enthaltenden Ebene der thermoplastischen Zwischenschicht auf die Außenscheibe (1) beträgt, oder
(ii) falls sich das mindestens eine erste elektrische Funktionselement (5) zwischen der metallischen Schutzschicht (16) und der Innenscheibe (2) befindet, eine Fläche der orthogonalen Projektion der metallischen Schutzschicht (16) auf die Innenscheibe (2) mindestens 90% einer Fläche der orthogonalen Projektion einer das mindestens eine erste Funktionselement (5) enthaltenden Ebene der thermoplastischen Zwischenschicht auf die Innenscheibe (2) beträgt.

7. Verbundscheibe (100) nach einem der Ansprüche 1 bis 6, bei welcher die metallische Schutzschicht (16) geerdet ist.

8. Verbundscheibe (100) nach einem der Ansprüche 1 bis 7, bei welcher eine Schicht (18) aus thermoplastischem Material mit einer Dicke von mindestens 0,3 mm zwischen dem mindestens einen ersten elektrischen Funktionselement (5) und dem mindestens einen zweiten elektrischen Funktionselement (8-1, 8-2) angeordnet ist.

9. Verbundscheibe (100) nach einem der Ansprüche 1 bis 8, bei welcher die metallische Schutzschicht (16) mit einem Massenanschluss (11) des OLED-Displays (5) elektrisch verbunden ist.

10. Verbundscheibe (100) nach einem der Ansprüche 1 bis 9, bei welcher die thermoplastische Zwischenschicht (3) umfasst:
- eine erste Schicht (4) aus einem thermoplastischen Material, welche das mindestens eine erste elektrische Funktionselement (5) enthält,
- eine zweite Schicht (7) aus einem thermoplastischen Material, welche das mindestens eine zweite elektrische Funktionselement (8-1, 8-2) enthält,
- eine dritte Schicht (14) aus einem thermoplastischen Material, welches eine seitlich aus der Verbundscheibe (100) geführte Anschlussleitung (6), insbesondere einen Flachbandleiter, für das mindestens eine erste elektrische Funktionselement (5) enthält.

11. Verbundscheibe (100) nach Anspruch 10, bei welcher die metallische Schutzschicht (16) auf eine Trägerfolie (15) aufgebracht ist, wobei beidseitig der Trägerfolie (15), unmittelbar angrenzend an die Trägerfolie (17), jeweils eine Schicht (17, 18) aus einem thermoplastischen Material angeordnet ist.

12. Verbundscheibe (100) nach Anspruch 10 oder 11, bei welcher unmittelbar angrenzend an die Innenscheibe (2) eine vierte Schicht (13) aus einem thermoplastischen Material und/oder unmittelbar angrenzend an die Außenscheibe (1) eine fünfte Schicht (14) aus einem thermoplastischen Material angeordnet ist.

13. Verfahren zur Herstellung einer Verbundscheibe (100) nach einem der Ansprüche 1 bis 12, welches die folgenden Schritte umfasst:
- Herstellen einer Stapelfolge aus einer Außenscheibe (1), einer Innenscheibe und einer thermoplastischen Zwischenschicht (3), wobei die thermoplastische Zwischenschicht mindestens ein erstes elektrisches Funktionselement (5) und mindestens ein zweites elektrisches Funktionselement (8-1, 8-2) umfasst, zwischen denen eine metallische Schutzschicht (18) angeordnet ist,
- Laminieren der Stapelfolge zu einer Verbundscheibe (100).

14. Verwendung der Verbundscheibe (100) nach einen der Ansprüche 1 bis 12 in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheiben und/oder Dachscheibe sowie als funktionales Einzelstück, und als Einbauteil in Möbeln, Geräten und Gebäuden, insbesondere als elektrischer Heizkörper, oder als Gebäudeverglasung im Baubereich oder Architekturbereich im Innenbereich oder Außenbereich.

## Claims

1. Laminated pane (100) comprising:
an outer pane (1) and an inner pane (2), which are firmly connected to one another by at least one thermoplastic intermediate layer (3), the intermediate layer (3) having at least one first electrical functional element (5) and at least one second electrical functional element (8-1, 8-2), supplied by an AC voltage, at least one metallic protective layer (16) being arranged between the two electrical functional elements (5, 8-1, 8-2) for shielding of field-bound interferences generated by the second electrical functional element (8-1, 8-2), wherein the at least one first electrical functional element is an OLED display and the at least one second electrical functional element is a PDLC film (8-1) and/or an OLED light source.

2. Laminated pane (100) according to claim 1, wherein the metallic protective layer (16) comprises or consists of at least one metal layer, preferably an aluminum layer, a stainless steel layer, a copper layer, a silver layer or a gold layer.

3. Laminated pane (100) according to claim 1, in which the metallic protective layer (16) is arranged on a carrier film (15), in particular a polymeric carrier film which contains or consists of, for example, polyethylene terephthalate (PET), polyvinyl butyral (PVB), ethylene vinyl acetate (EVA), polyethylene naphthalate (PEN), polyepoxide or polyimide.

4. Laminated pane (100) according to any one of claims 1 to 3, wherein the metallic protective layer (16) comprises or consists of a metallic foil, in particular an aluminum foil, a stainless steel foil, a copper foil, a silver foil or a gold foil.

5. Laminated pane (100) according to any one of claims 1 to 4, in which the metallic protective layer (16) has a thickness of from 0.5 µm to 500 µm, in particular from 1 µm to 200 µm and in particular from 20 µm to 50 µm, the metallic protective layer (16) preferably being transparent to light visible to the human eye.

6. Laminated pane (100) according to any one of claims 1 to 5, in which
(i) if the at least one first electrical functional element (5) is located between the metallic protective layer (16) and the outer pane (1), an area of the orthogonal projection of the metallic protective layer (16) onto the outer pane (1) is at least 90% of an area of the orthogonal projection of a plane of the thermoplastic intermediate layer containing the at least one first functional element (5) onto the outer pane (1), or
(ii) if the at least one first electrical functional element (5) is located between the metallic protective layer (16) and the inner pane (2), an area of the orthogonal projection of the metallic protective layer (16) onto the inner pane (2) is at least 90% of an area of the orthogonal projection of a plane of the thermoplastic intermediate layer containing the at least one first functional element (5) onto the inner pane (2).

7. Laminated pane (100) according to any one of claims 1 to 6, wherein the metallic protective layer (16) is grounded.

8. Laminated pane (100) according to any one of claims 1 to 7, wherein a layer (18) of thermoplastic material with a thickness of at least 0.3 mm is arranged between the at least one first electrical functional element (5) and the at least one second electrical functional element (8-1, 8-2).

9. Laminated pane (100) according to any one of claims 1 to 8, wherein the metallic protective layer (16) is electrically connected to a ground terminal (11) of the OLED display (5).

10. Laminated pane (100) according to any one of claims 1 to 9, wherein the thermoplastic intermediate layer (3) comprises:
- a first layer (4) of a thermoplastic material containing the at least one first electrical functional element (5),
- a second layer (7) of a thermoplastic material containing the at least one second electrical function element (8-1, 8-2)
- a third layer (14) made of a thermoplastic material, which contains a connection line (6), in particular a flat ribbon conductor, for the at least one first electrical functional element (5), which is roped out of the laminated pane (100).

11. Laminated pane (100) according to claim 10, in which the metallic protective layer (16) is applied to a carrier film (15), a layer (17, 18) of a thermoplastic material being arranged in each case on both sides of the carrier film (15), directly adjacent to the carrier film (17).

12. Laminated pane (100) according to claim 10 or 11, in which a fourth layer (13) of a thermoplastic material is arranged directly adjacent to the inner pane (2) and/or a fifth layer (14) of a thermoplastic material is arranged directly adjacent to the outer pane (1).

13. Method of manufacturing a laminated pane (100) according to any one of claims 1 to 12, comprising the following steps:
- producing a stacking sequence of an outer pane (1), an inner pane and a thermoplastic intermediate layer (3), wherein the thermoplastic intermediate layer comprises at least a first electrical function element (5) and at least a second electrical function element (8-1, 8-2), between which a metallic protective layer (18) is arranged,
- laminating the stacking sequence into a composite pane (100).

14. Use of the laminated pane (100) according to any one of claims 1 to 12 in means of transport for land, air or water traffic, in particular in motor vehicles, for example as a windshield, rear window, side windows and/or roof pane, and as a functional single piece, and as a built-in part in furniture, appliances and buildings, in particular as an electric radiator, or as building glazing in the construction sector or architectural sector, indoors or outdoors.

## Revendications

1. Vitrage feuilleté (100) comprenant :
une vitre extérieure (1) et une vitre intérieure (2), qui sont solidement reliées l'une à l'autre par au moins une couche intermédiaire thermoplastique (3), la couche intermédiaire (3) comportant au moins un premier élément fonctionnel électrique (5) et au moins un deuxième élément fonctionnel électrique (8-1, 8-2), alimentés par une tension alternative, au moins une couche protectrice métallique (16) étant disposée entre les deux éléments fonctionnels électriques (5, 8-1, 8-2) pour le blindage des interférences liées au champ générées par le deuxième élément fonctionnel électrique (8-1, 8-2), dans lequel le au moins un premier élément fonctionnel électrique est un écran OLED et le au moins un deuxième élément fonctionnel électrique est un film PDLC (8-1) et/ou une source lumineuse OLED.

2. Vitrage feuilleté (100) selon la revendication 1, dans lequel la couche protectrice métallique (16) comprend ou est constituée d'au moins une couche métallique, de préférence une couche d'aluminium, une couche d'acier inoxydable, une couche de cuivre, une couche d'argent ou une couche d'or.

3. Vitrage feuilleté (100) selon la revendication 1, dans lequel la couche protectrice métallique (16) est disposée sur un film support (15), en particulier un film support polymère qui contient ou est constitué, par exemple, de du polyéthylène téréphtalate (PET), du polyvinylbutyral (PVB), de l'éthylène-acétate de vinyle (EVA), du polyéthylène naphtalate (PEN), du polyépoxyde ou du polyimide.

4. Vitrage feuilleté (100) selon l'une quelconque des revendications 1 à 3, dans lequel la couche protectrice métallique (16) comprend ou est constituée d'une feuille métallique, en particulier une feuille d'aluminium, une feuille d'acier inoxydable, une feuille de cuivre, une feuille d'argent ou une feuille d'or.

5. Vitrage feuilleté (100) selon l'une quelconque des revendications 1 à 4, dans laquelle la couche protectrice métallique (16) a une épaisseur comprise entre 0,5 µm et 500 µm, en particulier entre 1 µm et 200 µm et en particulier entre 20 µm et 50 µm, la couche protectrice métallique (16) étant de préférence transparente à la lumière visible par l'œil humain.

6. Vitrage feuilleté (100) selon l'une quelconque des revendications 1 à 5, dans lequel
(i) si le au moins un premier élément fonctionnel électrique (5) est situé entre la couche protectrice métallique (16) et la vitre extérieure (1), une zone de la projection orthogonale de la couche protectrice métallique (16) sur la vitre extérieure (1) représente au moins 90 % d'une zone de la projection orthogonale d'un plan de la couche intermédiaire thermoplastique contenant le au moins un premier élément fonctionnel (5) sur la vitre extérieure (1), ou
(ii) si le au moins un premier élément fonctionnel électrique (5) est situé entre la couche protectrice métallique (16) et la vitre intérieure (2), une zone de la projection orthogonale de la couche protectrice métallique (16) sur la vitre intérieure (2) représente au moins 90 % d'une zone de la projection orthogonale d'un plan de la couche intermédiaire thermoplastique contenant le au moins un premier élément fonctionnel (5) sur la vitre intérieure (2).

7. Vitrage feuilleté (100) selon l'une quelconque des revendications 1 à 6, dans lequel la couche protectrice métallique (16) est mise à la terre.

8. Vitrage feuilleté (100) selon l'une quelconque des revendications 1 à 7, dans lequel une couche (18) de matériau thermoplastique d'une épaisseur d'au moins 0,3 mm est disposée entre le au moins un premier élément fonctionnel électrique (5) et le au moins un deuxième élément fonctionnel électrique (8-1, 8-2).

9. Vitrage feuilleté (100) selon l'une quelconque des revendications 1 à 8, dans lequel la couche protectrice métallique (16) est reliée électriquement à une borne de masse (11) de l'écran OLED (5).

10. Vitrage feuilleté (100) selon l'une quelconque des revendications 1 à 9, dans lequel la couche intermédiaire thermoplastique (3) comprend :
- une première couche (4) en un matériau thermoplastique contenant au moins un premier élément fonctionnel électrique (5),
- une deuxième couche (7) en un matériau thermoplastique contenant au moins un deuxième élément fonctionnel électrique (8-1, 8-2)
- une troisième couche (14) constituée d'un matériau thermoplastique, qui contient une ligne de connexion (6), en particulier un conducteur à ruban plat, pour le au moins un premier élément fonctionnel électrique (5), qui est tiré hors de la vitre feuilletée (100).

11. Vitrage feuilleté (100) selon la revendication 10, dans lequel la couche protectrice métallique (16) est appliquée sur un film support (15), une couche (17, 18) d'un matériau thermoplastique étant disposée de chaque côté du film support (15), directement adjacente au film support (17).

12. Vitrage feuilleté (100) selon la revendication 10 ou 11, dans lequel une quatrième couche (13) d'un matériau thermoplastique est disposée directement adjacente à la vitre intérieure (2) et/ou une cinquième couche (14) d'un matériau thermoplastique est disposée directement adjacente à la vitre extérieure (1).

13. Procédé de fabrication d'un vitrage feuilletée (100) selon l'une quelconque des revendications 1 à 12, comprenant les étapes suivantes :
- la production d'une séquence d'empilement d'une vitre extérieure (1), d'une vitre intérieure et d'une couche intermédiaire thermoplastique (3), dans laquelle la couche intermédiaire thermoplastique comprend au moins un premier élément fonctionnel électrique (5) et au moins un deuxième élément fonctionnel électrique (8-1, 8-2), entre lesquels est disposée une couche protectrice métallique (18),
- laminage de la séquence d'empilement en un vitrage feuilletée (100).

14. Utilisation du vitrage feuilletée (100) selon l'une quelconque des revendications 1 à 12 dans des moyens de transport terrestre, aérien ou aquatique, en particulier dans des véhicules à moteur, par exemple comme pare-brise, vitre arrière, vitre latérale et/ou vitre de toit, et comme pièce fonctionnelle monobloc, et comme élément intégré dans des meubles, des appareils et des bâtiments, en particulier comme radiateur électrique, ou comme vitrage de bâtiment dans le secteur de la construction ou de l'architecture, à l'intérieur ou à l'extérieur.
